(19) Europäisches Patentamt / European Patent Office / Office européen des brevets

(11) **EP 4 242 679 A1**

(12) **EUROPEAN PATENT APPLICATION**

(43) Date of publication:
**13.09.2023 Bulletin 2023/37**

(21) Application number: **22305258.0**

(22) Date of filing: **07.03.2022**

(51) International Patent Classification (IPC):
*G01R 33/32* (2006.01)    *G01R 33/26* (2006.01)
*G01N 24/00* (2006.01)    *G01R 33/032* (2006.01)

(52) Cooperative Patent Classification (CPC):
**G01R 33/323; G01N 24/006; G01R 33/26**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Wainvam-E**
**56270 Ploemeur (FR)**

(72) Inventors:
• **BABASHAH, Hossein**
**1022 Chavannes-près-Renens (CH)**
• **HINGANT, Thomas**
**35000 Rennes (FR)**
• **GALLAND, Christophe**
**1092 Belmont sur Lausanne (CH)**
• **RANI, Dipti**
**56100 Lorient (FR)**
• **GEIGER, Remi**
**56530 Quéven (FR)**

(74) Representative: **Novagraaf Technologies**
**Bâtiment O2**
**2, rue Sarah Bernhardt**
**CS90017**
**92665 Asnières-sur-Seine Cedex (FR)**

(54) **A SOURCE OF FLUORESCENCE SHAPED AS A DIAMOND WAVEGUIDE**

(57)    A source of fluorescence is described. The source of fluorescence shaped as a diamond waveguide comprising defects in a diamond configured to emit a fluorescence when submitted to an excitation light provided by a source of excitation, and an inlet through which said excitation light is arranged to be introduced, wherein said diamond waveguide has an elongated shape and is arranged to couple said excitation light and said defects through the length of the diamond waveguide. Sensor devices comprising said source of fluorescence is also disclosed. A magnetometer comprising said sensor device is also disclosed.

**FIG. 15a**

EP 4 242 679 A1

**Description**

TECHNICAL FIELD

A source of fluorescence shaped as a diamond waveguide and a sensor device comprising this source of fluorescence and coupled to a fluorescence collector is described. Applications include magnetometry, in which the source of fluorescence can be a nitrogen-vacancy diamond. A magnetometer comprising a sensor device is also described.

BACKGROUND

Magnetometers based on the probing of the energy level differences in Nitrogen Vacancy (NV) color centers in diamond are a promising technology, for example for magnetic field stabilization. In such a case, the NV magnetometer is used to measure the fluctuations of a supposedly constant, or slowly varying magnetic field, in order to compensate these fluctuations. In order to be able to measure efficiently fields with high intensities (>30 mT), the NV center has to be aligned with the field to measure. Using a fiber allows accessing regions where space is constrained, like in the case of atomic physics experiments, where several lasers address the same atomic cloud (where the field needs to be controlled). Hence, a small and remote sensor is desirable.

It has been proposed to use an optical fiber to excite an NV diamond and to collect the resulting fluorescence. Indeed, coupling NV diamonds to fibers make them good candidates for performing magnetometry in challenging environments. An NV-based magnetometer in which an optical fiber is used is described by Chatzidrosos, Georgios, et al. "Fiberized Diamond-Based Vector Magnetometers." Frontiers in Photonics, 2021.

In particular, NV color centers in diamonds are promising due to their spin coherence time even at room temperature. These NV color centers are sensitive to small fluctuations in magnetic fields. The sensitivity of sensors comprising such a NV diamond is proportional to the square root of the number of excited NV color centers as well as to the rate of the collection of the resulting fluorescence.

In order to improve the excitation of the NV diamond and the collection of the resulting fluorescence, several structures have been investigated to guide the excitation light within the diamond comprising the NV color centers, as described by [1], [2]. In particular, [2] proposes a sensor comprising a waveguide in which a rectangular single-crystal diamond is cut at one of its corners at an angle of 45 degrees. As a result, this cut ensures an improved trapping of light with a perpendicular incidence on the cut inside the NV diamond. However, this proposal has several drawbacks.

Indeed, in this proposal, the light does not travel through the entire NV diamond and as a result, the structure of the NV diamond is not utilized optimally. Inhomogeneous excitation of the NV diamond will result in lower sensitivity of the sensor. Additionally, the collection of the resulting fluorescence is not efficiently carried out. In fact, in the proposal of [2], the excitation of the NV diamond is critical as it is required that the incident light to be perfectly aligned for improved trapping of the light within the NV diamond.

It is therefore desirable to reduce at least certain of these drawbacks. In particular, it is desirable to provide a NV diamond in which the excitation is homogeneous, and in which the collection of the resulting fluorescence is carried out efficiently. Enhancing the excitation and collection also enhances the sensitivity of miniaturized NV diamond based sensor devices to small fluctuations of magnetic fields.

SUMMARY

The project leading to this patent application has received funding from the European Union's Horizon 2020 research and innovation programme under the Marie Sklodowska-Curie grant agreement No 754354.

The scope of protection is set out by the claims.

A first aspect concerns a source of fluorescence shaped as a diamond waveguide comprising:

- defects in a diamond configured to emit a fluorescence when submitted to an excitation light provided by a source of excitation, and
- an inlet through which said excitation light is arranged to be introduced,
  wherein said diamond waveguide has an elongated shape and is arranged to couple said excitation light and said defects through the length of the diamond waveguide.

The source of fluorescence corresponds to a device comprising waveguide, said waveguide being made of diamond-based material arranged to produce fluorescence.

According to an embodiment, said defects comprise nitrogen-vacancy centers, said fluorescence is function of a physical phenomenon to be sensed such as a magnetic field, temperature, pressure, or an electric field.

According to an embodiment, said diamond waveguide is formed in a photonic crystal structure, the periodicity of the photonic crystal structure being of the same order of magnitude as the wavelength of excitation light and/or with the wavelength of the fluorescence.

According to an embodiment, said diamond waveguide has the shape of a spiral comprising turns having a common center and two coplanar branches connected at said common center, said spiral being in a first plane.

According to an embodiment, said elongated diamond waveguide comprises at least 5 turns.

According to an embodiment, said elongated diamond waveguide is a single-mode waveguide or a multimode-waveguide having a roughness at its side wall surfaces lower than 100 nm and each turn being defined by a radius of curvature higher than 50 $\mu$m.

According to an embodiment, the diamond waveguide is coated with a first reflective coating, a material of said first reflective coating being adapted to reflect both fluorescence and excitation light.

A second aspect concerns a sensor device comprising:

- a source of fluorescence according to one of the embodiments of the first aspect;
- a first optical fiber arranged to channel said excitation light to said inlet of said diamond waveguide;
- a second optical fiber arranged to collect said fluorescence.

According to an embodiment of the first aspect, said diamond waveguide comprises a second reflective coating arranged to reflect both excitation light and fluorescence from an extremity of said waveguide opposite to said inlet, a material of said second reflective coating being adapted to reflect both fluorescence and excitation light.

A third aspect concerns a sensor device comprising:

- a source of fluorescence according to the above embodiment of the first aspect;
- a single optical fiber is arranged to channel said excitation light to said diamond waveguide and to collect said fluorescence.

According to an embodiment of the second or third aspects, said diamond waveguide comprises a first grating coupler configured to be connected to said source of excitation and/or a second grating coupler configured to be connected to said collector

According to an embodiment of the second or third aspects, said diamond waveguide is deposited on a first side of a substrate, said first side being in a second plane.

According to an embodiment of the second or third aspects, the sensor device further comprises a coplanar microwave resonator optionally deposited on an opposite side of the first side of the substrate, said opposite side being in a third plane.

According to an embodiment of the second or third aspects, said diamond waveguide has the shape of a spiral comprising turns having a common center and two coplanar branches connected at said common center, said spiral being in a first plane, wherein a first optical fiber is arranged to channel said excitation light to said waveguide from a direction substantially perpendicular to said first plane, wherein a second optical fiber is arranged to collect the fluorescence from a direction substantially perpendicular to said first plane.

A fourth aspect concerns a magnetometer comprising a sensor device according to one of the embodiments of the second or third aspects.

The designs described herein are scalable and can be used for any size of a NV diamond, as needed by a specific application. For example, the diamond waveguide can further have a shape of spiral, of meander lines, of a serpentine, of one or more straigh line segment, etc. The use of these designs is to increase the excited number of NV centers inside the diamond waveguide, in order to obtain an increased fluorescence, and, consequently, to significantly increase the sensitivity of the measurement.

The designs according to the exemplary embodiments can be integrated and their manufacturing process can be easily scaled.

The embodiments use the green light excitation in a very efficient way by exciting a large part of the NV color centers embedded in the NV diamond of the sensor.

Specific applications include neuroimaging, protein sensing, nuclear magnetic resonance (NMR), quantum computing, lab-on-chip for applications in biology or medicine comprising measurements related to cells, diamond NV lasers, arrays of sensors for imaging current, non-destructive testing (e.g. of defects in metals), for example deposited on an $SiO_2$ substrate bonded to a NV diamond.

The designs described herein are scalable and can be used for any size of a high refractive index media, such as diamond, as needed by a specific application.

BRIEF DESCRIPTION OF THE DRAWINGS

Example embodiments will be more fully understood from the detailed description provided herein and the accompanying drawings, which are given by way of illustration only.

FIG. 1 is a schematic representation of a diamond and its carbon atoms (C), and comprising a nitrogen atom (N) and a vacancy (V), the latter two forming an 'NV center';
FIG. 2 is a schematic diagram of the energy levels of an NV center;
FIG. 3 is a graph of ODMR (Optically Detected Magnetic Resonance) data obtained by measuring the red fluorescence for different magnetic field values;
FIG. 4 is a block diagram of the components of an NV magnetometer according to an exemplary embodiment;
FIG. 5 is a schematic view of an example of a photonic crystal structure;
FIG. 6 is a schematic view of a NV diamond waveguide formed in a photonic diamond structure according to a non-limiting exemplary embodiment;
FIG. 7 represents graph showing a simulation result of the propagation of a green light in a NV diamond waveguide formed in a photonic diamond structure according to a non-limiting exemplary embodiment;
FIG. 8 represents a chart plotting the transmission coefficient of the NV diamond waveguide formed in a photonic diamond structure according to the FIG. 7 as a function of the wavelength of the collected red light;
FIG. 9 is a chart plotting the scattering loss in dB/90 degree as a function of the radius of curvature in $\mu$m of a nitrogen-vacancy diamond single-mode waveguide;
FIG. 10 is a chart plotting the scattering loss in dB/90 degree as a function of the roughness in nm of a nitrogen-vacancy diamond single-mode waveguide;
FIG. 11 is a chart plotting the scattering loss in dB/90 degree as a function of the radius of curvature in $\mu$m of a nitrogen-vacancy diamond multimode waveguide;
FIG. 12 is a graph of surface roughness generated for a 1 mm $\times$ 20 $\mu$m $\times$ 40 $\mu$m elongated NV diamond multimode waveguide for the upper surface and lower surface;
FIG. 13 is a chart plotting the scattering loss in dB/mm as a function of the roughness in nm of the nitrogen-vacancy diamond multimode waveguide;
FIG. 14a is a schematic view of a non-limiting exemplary embodiment of a nitrogen-vacancy diamond waveguide having the shape of a Fermat's spiral and FIG. 14b is a chart plotting the luminescence in lm as a function of the number of turns according to this non-limiting exemplary embodiment;
FIGS. 15a and 15b are respectively a schematic top view and a schematic bottom view of a sensor device according to a non-limiting exemplary embodiment;
FIG 16(a)-(f) are schematic diagrams of an example of method of manufacturing a NV diamond waveguide according to an embodiment of the invention.

It should be noted that these figures are intended to illustrate the general characteristics of methods, structure and/or materials utilized in the described exemplary embodiments. The drawings are not to scale and should not be interpreted as limiting the range of values or properties encompassed by the exemplary embodiments.

DETAILED DESCRIPTION

Various exemplary embodiments will now be described more fully with reference to the accompanying drawings. However, specific structural and functional details disclosed herein are merely representative for purposes of describing example embodiments. The exemplary embodiments may be embodied in many alternate forms and should not be construed as limited to only the embodiments set forth herein. It should be understood that there is no intent to limit example embodiments to the particular forms disclosed.
It should be appreciated by those skilled in the art that any functions, engines, block diagrams, flow diagrams, state transition diagrams and / or flowcharts herein represent conceptual views of illustrative circuitry embodying the principles of the exemplary embodiments. Functions, actions or steps described herein can be implemented in hardware or software or any combination thereof. If implemented in software, the functions, blocks of the block diagrams and/or flowchart illustrations can be implemented e.g. using software code executed by a processor or a processing device.
In the present description, functional blocks denoted as "means configured to perform ..." a certain function shall be understood as functional blocks comprising circuitry that is adapted for performing or configured to perform a certain function. A means being configured to perform a certain function does, hence, not imply that such means necessarily is performing said function (at a given time instant). Moreover, any entity described herein as "means", may be implemented as one or more distinct entities or within an entity providing additional functions. When provided by a processor, the functions may be provided by a single processor or several processors. Moreover, the term "processor" includes one or more of a digital signal processor, remote 'cloud' processor, graphical processing units, dedicated or generic circuitry, read only memory for storing software, random access memory, and non-volatile storage.

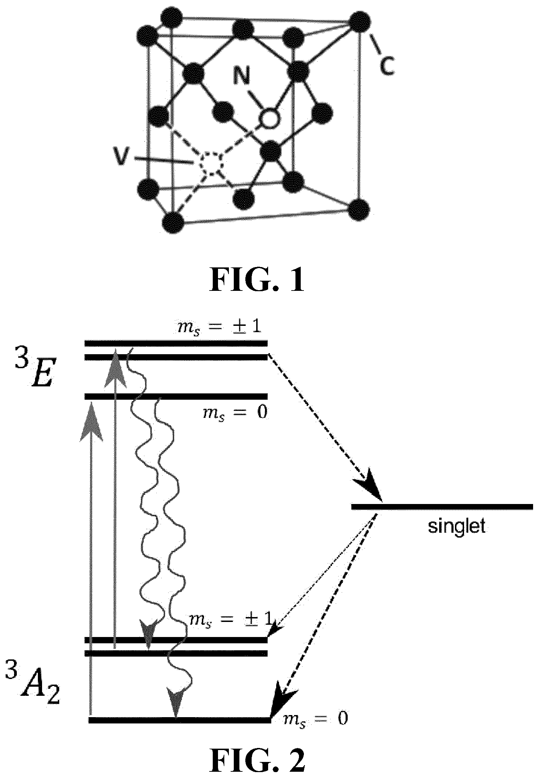

NV magnetometry is based on the use of a particular defect of the diamond lattice in the solid state. The term NV (Nitrogen-Vacancy) center refers to the substitution of a carbon atom by a nitrogen atom, directly adjacent to a lattice vacancy (a missing carbon atom), as shown in FIG. 1. This defect presents energy levels and various interesting physical characteristics, which can be used in a magnetic field sensor. These measurements can also be used to determine temperatures, electric fields, strains and pressure. In particular, when a NV diamond (containing millions of NV centers) is irradiated with green light (e.g. coming from a laser or a LED), it fluoresces red light with an intensity generally proportional to the irradiation.

FIG. 2 is a schematic diagram of the energy levels of the NV center, and showing the ground state triplet state 3A2, the excited triplet state 3E and the singlet state. Owing to quantum mechanical selection rules, when the NV center is in the ms = 0, respectively ms = ± 1 state, in the ground state, it tends to stay in the ms = 0, respectively ms = ± 1, state when absorbing a green photon from the excitation light source, as shown by the two upward oriented straight arrows. Similar selection rules apply when the NV center is de-excited from the excited state to the ground state by the emission of a red fluorescence photon, as shown by the two downward oriented wobbly arrows. However, when the NV center lands in the ms = ± 1 levels in the excited state, it has a larger (about 7 times) probability to decay non radiatively in the singlet state than when in the ms = 0 excited state. From the singlet state, the NV center returns preferentially (with twice larger probability) to the ms = 0 ground state. As a result, the NV center can be optically polarized in the ms = 0 ground state through the application of green excitation light. Red fluorescence is emitted owing to the radiative decay from the excited state to the ground state. This level of fluorescence varies depending on the initial spin level of the NV center in the ground state: more fluorescence is recorded when the NV center is initially in the ms = 0 spin level than in the ms = ± 1 levels, owing to the non-radiative transitions through the singlet state in the second case.

A microwave field with a frequency around 2.87 GHz can be applied to change the spin state of the NV center in its ground state from ms = 0 to ms = 1 or ms = -1. When the frequency of the microwave field is resonant with the energy level difference, less red fluorescence is observed. This phenomenon is called Optically Detected Magnetic Resonance ('ODMR').

A magnetic field lifts the degeneracy between the ms = 1 and ms = -1 levels. Therefore, when a magnetic field is applied to the NV center, two frequencies for which the fluorescence decreases can be observed. In a first approach, one can consider that the two frequencies are linearly related to the magnitude of the magnetic field:

$$f_{res} = 2.87\,\mathrm{GHz} \pm \frac{\gamma}{2\pi}\mathbf{B} \qquad (\mathrm{Eq.}\,1)$$

where B is the magnetic field aligned with the axis of the NV center (i.e. the axis defined by the alignment of the nitrogen atom and the gap) and $\gamma$ is the gyromagnetic ratio of the NV center: $\gamma/2\pi$=28 GHz/T.

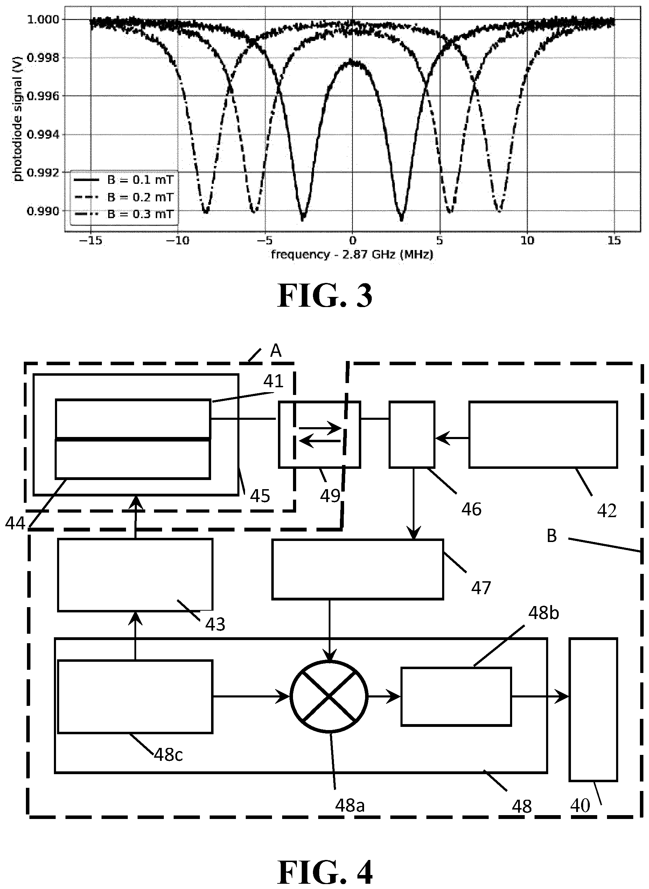

FIG. 3 is a graph of simulated ODMR data that can be obtained by measuring the red fluorescence for different magnetic field values. For each value of the magnetic field, the two resonance dips in the photodiode output signal and centered around the excitation frequency appear clearly. The spacing of the dips increases with the intensity of the magnetic field. Since the NV centers can exist in four different directions within the diamond, a total of four pairs of two resonances can actually be observed, each pair corresponding to a projection of the magnetic field vector onto a given direction of an NV axis. This allows to univocally identify the three spatial components of the magnetic field, and thus to obtain a vector measurement of the latter. The NV sensor allows an accurate vector measurement of a magnetic field, with a good sensitivity: the latter is often limited by the photon shot noise of the fluorescence light, reaching typical values ranging from pT/ √ Hz to nT/ √ Hz depending on the sensor design.

FIG. 4 is a block diagram of the components of a non-limiting exemplary embodiment of an NV magnetometer shown with the purpose of describing various components used therein. The device of FIG. 4 comprises two subsystems: sensor head A and excitation/readout/processing module B. In the device of FIG. 4, the same fiber is used both to carry the excitation light for the NV diamond and to collect the resulting fluorescence emitted by NV centers. However, according to other embodiments described later on, distinct fibers can be used to perform each of these functions.

According to one embodiment, the sensor head A comprises:

1. An NV diamond 41
2. An optical fiber associated with the NV diamond
3. A bias magnet 45

The magnetic bias may be provided by a permanent magnet for allowing to resolve the different magnetic resonances. A typical value of the bias field is around 30 mT, but this value is given purely as a non-limiting example. Other types of sources of a continuous magnetic field, such as a coil, micro Helmholtz coils or a Halbach array may also be used.

4. A microwave resonator 44

The resonator ensures a sufficiently strong coupling between the NV electronic spins and a microwave magnetic field provided by a microwave source 43 used to engage a physical phenomenon. As a non-limiting example, microwave magnetic field amplitudes of a few $10^{-4}$T can typically be used. Depending on the application, the resonator can be for example a printed circuit board-based resonator or broadband antenna, or a wire antenna made with copper.

5. As necessary, a substrate and /or mechanical components e.g. a housing for holding the diamond, the microwave resonator, the fiber and the magnet.

According to one embodiment, the excitation/readout/processing module B comprises:

6. A green light source 42 used as a source of excitation.
This light source may be a laser or a LED, for example with a power in the range 1 - 100 mW at the wavelength in the range 510 - 550 nm and stabilized in power to ensure low enough relative intensity noise (RIN) level.

7. A microwave source 43, the tunable frequency of which is around 2.87 GHz, coupled to microwave resonator 44. The microwave source is driven by a local oscillator 48c.

8. A green/red light separator 46

A green/red light separator 46 is used to separate the green light being injected into the optical fiber and the fluorescence emitted by the NV centers and having a wavelength at around 650 nm. The red fluorescence is re-emitted into the same fiber that also carries the green excitation light provided by source 42, hence the use of the separator, which can be a dichroic optical element or any optical system that can separate the green and red light.

As will be described in detail later, some embodiments do not require a green/red light separator.

9. A photodetector 47

In the present embodiment, the photodetector 47 is a photodiode, although other photodetectors may be used. The photodiode is used to detect the red light received as output from separator 46. The photodiode can be used in conjunction with a transimpedance amplifier (not shown) to generate a voltage based on the photodiode output and to feed the next stage.

10. A lock-in amplifier 48

The lock-in amplifier receives the signal from the photodiode 47 and its associated amplification means. The lock-in amplifier comprises a mixer 48a and a low-pass filter 48b. The mixer 48a is driven by local oscillator 48c, which according to one non-limiting embodiment is part of the lock-on amplifier.

11. A processor 40

The processor may advantageously be located remotely compared to the sensor head A. It acquires and processes the information provided by the lock-in amplifier. It is also used to control a user interface for communication with the user. The processor executes software code stored in a memory (not shown). The processor is part of a control module which may comprise other components. According to certain embodiments, the processor processes signals provided by a plurality of photodiodes.

The sensor head A and the excitation/readout/processing module B are connected through a connection module 49, the role of which is to optically connect the modules A and B, either directly or through one or more appropriately placed connectors.

According to an embodiment, the microwave source and the microwave resonator are connected through a cable e.g. running in parallel with the optical fiber. According to a variant embodiment, the connection module comprises one or more amplifiers for amplifying the microwave signal along the cable.

According to another embodiment, the microwave source produces microwaves that are optically transmitted and regenerated locally before being transmitted to the resonator.

In the present embodiment, the measurement of the magnetic field is performed via the lock-in amplifier and is based on a frequency modulation (FM) spectroscopy technique. The microwave signal generated by microwave source 43 is frequency modulated. The frequency fLO used for this frequency modulation may for example be 10 KHz. This in turn modulates the level of red fluorescence around the minimum of the resonance curve at the same frequency. The signal output from the photodiode is therefore modulated at fLO. The lock-in amplifier performs a synchronous detection by electronically mixing the signal coming from the photodiode with the local oscillator (LO) signal and by keeping only the slowly evolving part of the resulting signal, e.g. by applying low pass filter 48b. The resulting signal output from the lock-in amplifier is generally proportional to the derivative of the resonance and corresponds to a dispersive curve with a linear part that allows to translate the measured voltage into a frequency and therefore into a magnetic field value according to (see Eq.1 above).

Various features of a coupler device that can be used e.g. within a sensor head, such as sensor head A, will now be described. Each feature provides a distinct improvement of the efficiency of light collection and can be used in isolation or in combination with one, or several, or all other features. Certain combinations of features can however present distinct synergies and advantages.

The NV diamond, in particular an elongated NV diamond waveguide, is used as a source of fluorescence. The elongated NV diamond waveguide comprises two extremities, an extremity that is an inlet through which the excitation light is arranged to be introduced, and another extremity that can be either an outlet arranged to at least collect the fluorescence, or that can be arranged to reflect both the excitation light and the fluorescence from this extremity towards the inlet. The elongated NV diamond waveguide has a shape that is designed to couple the excitation light and the NV centers (that are defects). When the elongated NV diamond waveguide is deposited on a substrate, different parts of the elongated NV diamond waveguide can be separated: a lower part deposited on the substrate, an upper part opposite the lower part, and side wall surfaces connecting the lower part to the upper part. The use of an elongated NV diamond waveguide allows obtaining, when it is irradiated with a green light for example, the excitation of an increased number of NV centers as the light travels along the length of the waveguide, and therefore a higher level of fluorescence (in particular fluoresced red light) with an intensity generally proportional to the irradiation. The intensity of the fluorescence of this elongated NV diamond waveguide is function of a physical phenomenon to be sensed, for example a microwave magnetic field, temperature, pressure, or an electric field and is also function of the shape of the elongated NV diamond waveguide.

According to an embodiment, the elongated NV diamond waveguide is formed in a photonic structure, for example in a photonic crystal structure, which does not allow the green light and/or the fluoresced red light to pass through so that the green light and/or the fluoresced red light propagate in a direction along the elongation of the NV diamond waveguide. In particular, the photonic structure is positioned on either side of the elongated NV diamond waveguide, so that the green light and/or the fluoresced red light can exist only in the elongated NV diamond waveguide.

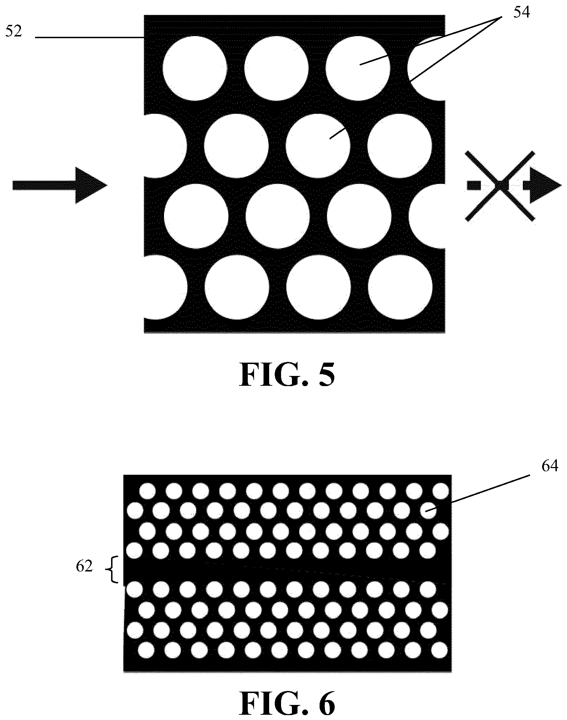

FIG. 5 is a schematic diagram of a photonic structure, where the photonic structure is based on a periodic structure 54. Advantageously, the photonic structure is a periodic structure 54 formed in a photonic crystal 52, the periodicity of the periodic structure 54 preferably being of the same order of magnitude as the wavelength of excitation light and/or with the wavelength of the fluorescence.

According to one embodiment, the photonic crystal structure is a photonic diamond structure, in particular a diamond crystal in which the elongated NV diamond waveguide is formed. This diamond crystal consists of an array of holes with a pitch period comprised between 400 nm and 700 nm and a hole diameter comprised between 200 and 400 nm. For example, the elongated NV diamond waveguide can be a waveguide with a straight line segment shape that can have a rectangular section. In the exemplary embodiment illustrated by FIG. 6, the diamond crystal comprises an array of cylindrical holes 64 with a pitch period of 650 nm and a diameter of 400 nm and the elongated NV diamond waveguide 62 has a straight line segment shape with a rectangular section having dimensions approximately equal to 825 nm. For example, the section of the elongated NV diamond waveguide 62 may be up to micrometers scale, in order to increase the intensity of the fluorescence, which directly impacts the sensitivity of the sensing device.

According to a non-limiting example, the photonic diamond structure can be manufactured, for example by etching holes in the diamond crystal.

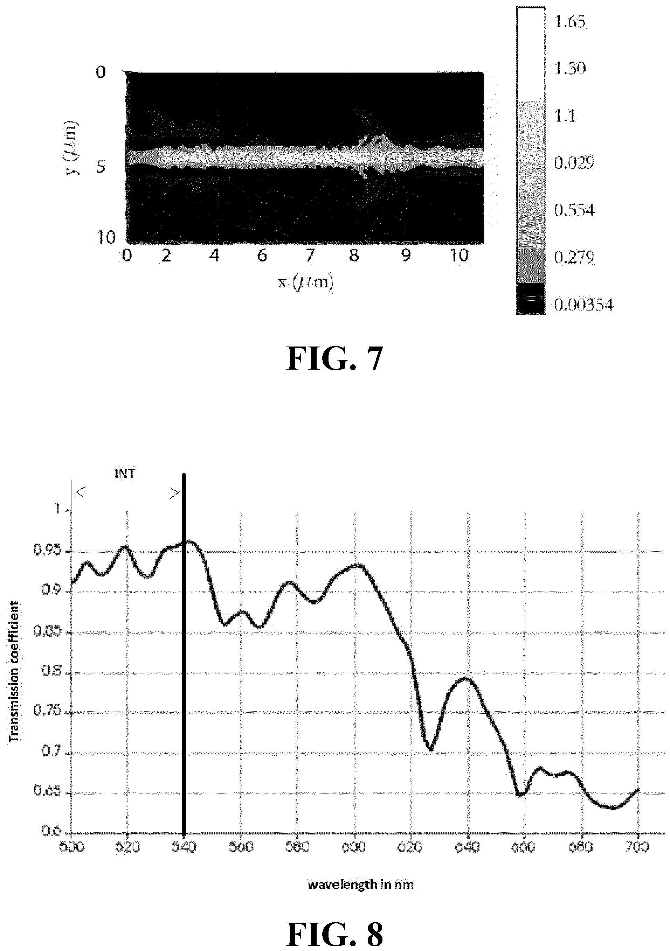

The result of a simulation for a green light (for example a wavelength of 532 nm) propagated in the exemplary embodiment illustrated by FIG. 6 is illustrated in FIG. 7. It is being observed that the green light is being coupled to the elongated NV diamond waveguide, with the green light propagating through the waveguide as indicated by the shade of grey referred to the legend, which represents the intensity of the electric field of the green light through the elongated NV diamond waveguide. The intensity of the transmitted and reflected green light is also shown in the graph of FIG. 8. This graph shows a transmission coefficient of the diamond photonic crystal waveguide better than 90% for the wavelengths of interest INT, i.e. for wavelengths comprised between 500 and 540 nm.

The use of this elongated NV diamond waveguide allows exciting a maximum number of NV centers with the input excitation light traveling along the length of the elongated NV diamond waveguide, and consequently generates significantly higher levels of fluorescence compared to known configurations of the NV diamond according to which a light spot irradiates on a region of surface of the diamond, and thus the number of excited NV centers is not optimized. Therefore, the sensitivity of a sensing device or magnetometer using such a kind of source of fluorescence can be significantly improved.

The elongated NV diamond waveguide can be appropriately polished or otherwise shaped using processes known to the person skilled in the art. For example, the elongated NV diamond waveguide may take the shape of a bar, a curved meander line, or a serpentine.

Advantageously, the elongated NV diamond waveguide can have a spiral shape comprising turns (or windings), the spiral being in a first plane. In particular, the shape of the spiral comprises turns having a common center and two coplanar branches connected at the common center. Preferably, these two branches are two spirals, one incoming and the other outgoing, these two spirals being around the common center. Preferably, these two branches are symmetric with regard to the common center. In particular, the elongated NV diamond waveguide has a continuous structure. For example, the spiral can be in a 2-dimensions plane, with an origin defined as the center of the spiral, the spiral can be parametrized by an angle and a radius (in radial coordinates). A full turn corresponds to a 2pi radian changes in the angle.

Advantageously, at this center, these two coplanar branches can be, for example, linked by a straight line, an Euler bend, or this center can be take the shape of the center of a Fermat's spiral shape.

The elongated NV diamond waveguide can be used as a single-mode or multi-mode optical waveguide (NV diamond single-mode or multi-mode waveguide). For both single-mode or multi-mode, there exist two major reasons for the optical propagation loss including the loss due to bending (in particular in view of the radius of curvature) of the elongated NV diamond single-mode or multi-mode waveguide and roughness present at side wall surfaces of the elongated NV diamond single-mode or multi-mode waveguide.

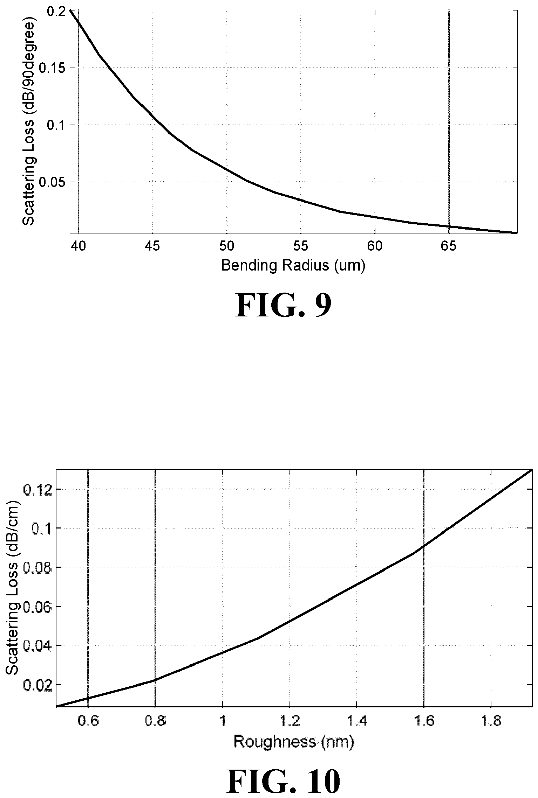

Thus, according to a first feature for an elongated NV diamond single mode waveguide with a spiral shape, an advantageous bending of the elongated NV diamond is determined. To this end, different radiuses of curvature were simulated with regard to the scattering loss of an elongated NV diamond waveguide attained when attached to the single-mode waveguide fiber and used as an optical waveguide. The results of the simulation for a 240 nm $\times$ 1 $\mu$m elongated NV diamond waveguide with a variation of its radius of curvature for a 90 degree turn, are shown in FIG. 9. It has been shown that the higher the radius of curvature, the less the scattering loss due to the bending of the elongated NV diamond waveguide. Advantageously, for the elongated NV diamond single mode waveguide, the radius of curvature of each turn of the spiral is maintained above 50 $\mu$m, and preferably higher than 100 $\mu$m.

Moreover, in order to use more efficiently the volume of the elongated NV diamond waveguide, many turns for the spiral are required. In particular, the higher the number of turns, the higher the number of NV centers that are excited homogenously throughout the volume of the elongated NV diamond waveguide leading to the enhanced sensitivity of the sensor device comprising this elongated NV diamond waveguide. Advantageously, for the elongated NV diamond single mode waveguide, the number of turns is greater than 5, and it is preferably comprised between 5 and 500.

According to a second feature for a NV diamond single mode waveguide with a spiral shape, an advantageous roughness of the NV diamond is determined. In fact, the roughness present at side wall surfaces of the NV diamond waveguide that can be introduced during manufacturing (in particular during an etching step) attenuates the optical signal propagating through the NV diamond single mode waveguide. To estimate such scattering loss, the so-called Tien theory as described in [3] can be applied. The theory predicts that the scattering loss coefficient ($\alpha$ in cm$^{-1}$) for the first transverse electric (TE) mode of a waveguide follows the equation below.

$$\alpha = \frac{8\pi^2}{\lambda^2} \times \frac{\cos^3 \theta}{\sin \theta} \times \frac{\sigma_{12}^2 + \sigma_{10}^2}{t + 1/p + 1/q}$$

In the equation, $\theta$ stands for the incident angle of light, $\sigma_{12}$ and $\sigma_{10}$ represent the surface roughness between the diamond-air interface and diamond silicon oxide interface respectively when the elongated NV diamond single mode waveguide is deposited on a silicon oxide substrate, t is the thickness of the elongated NV diamond single mode waveguide, and 1/p and 1/q are the penetration depths of the single mode into the cladding.

The result of this estimation, in which 1 dB/cm is equal to $0.0434 \times \alpha$, is shown in FIG. 10. The sub nanometer roughness in the elongated NV diamond single mode waveguide is enough to degrade the quality factor of the elongated NV diamond waveguide to less than $10^6$, with the quality factor Q being calculated using the equation

$$Q = \frac{2\pi n}{\alpha \lambda}.$$

Advantageously, for the elongated NV diamond single mode waveguide and in the frame of the proposed application, such a high-quality factor is not necessarily required and a roughness of a few nanometers is acceptable.

Thus, according to one embodiment, the elongated NV diamond waveguide is a single-mode waveguide having a spiral shape, for example the shape of a Fermat's spiral. Using such a spiral allows fitting a long waveguide into a small surface area. According to this embodiment, the side wall surfaces of the elongated NV diamond waveguide have a roughness lower than 50 nm, and the elongated NV diamond waveguide has a number of turns equals to 5, each turn having a radius of curvature higher than 50 $\mu$m.

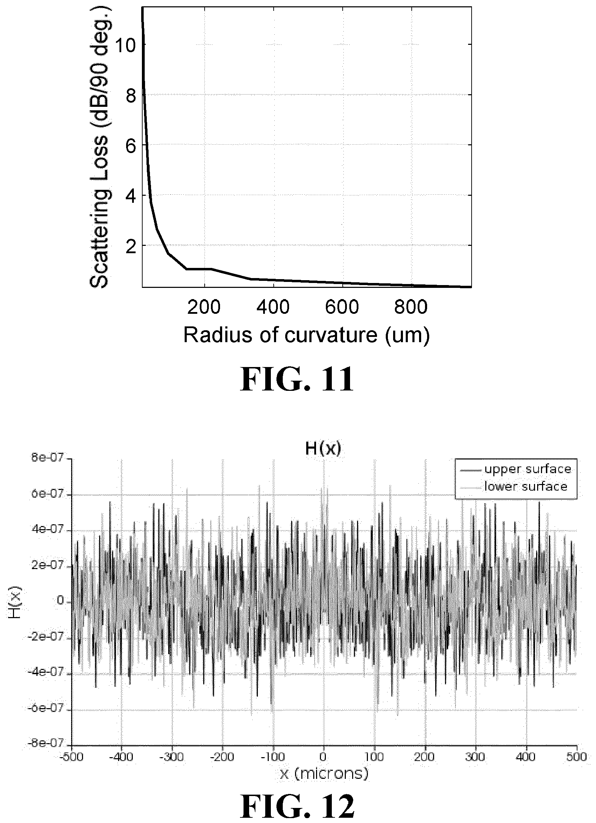

According to another embodiment, the NV diamond waveguide is a NV diamond multimode waveguide. According to a first feature of a multimode waveguide, an advantageous bending of the NV diamond is determined. To this end, different radiuses of curvature were simulated with regard to the scattering loss of a NV diamond waveguide attained when attached to the multi-mode waveguide fiber and used as an optical waveguide. The results of the simulation for an elongated NV diamond waveguide with a cross section of $20\mu m \times 40\mu m$ and total length of 9.5 mm with a variation of its radius of curvature for a 90 degree turn, are shown in FIG. 11. These results were obtained by varying the waveguide width and the radius of curvature within certain value ranges to reach the lowest attenuation, using an appropriate raytracing software such as the one available from ANSYS. It has been shown that the higher the radius of curvature, the less the scattering loss due to the bending of the NV diamond multimode waveguide. Further, the simulated ratio between an input optical power and an output optical power of the NV diamond multimode waveguide is shown in FIG. 11. FIG. 11 implies that a radius of curvature of 50 $\mu m$ for a NV diamond multimode waveguide will result approximatively in 3 dB loss of optical power. The higher attenuation of such a NV diamond multimode waveguide is due to the fact that different modes will exit the NV diamond multimode waveguide as the radius of curvature with respect to the NV diamond multimode waveguide cross section is very small as it goes to zero by approaching to the center. According to the simulation results, the NV diamond multimode waveguide in a spiral shape with radius curvature of around 100 $\mu m$ has a scattering loss of less than approximatively 1 dB. Advantageously, for the NV diamond multimode waveguide, the radius of curvature is higher than 50 $\mu m$ in order to have a sensor device that can be used with 5 number of turns. Preferably, the radius of curvature is higher than 90 $\mu m$.

According to a second feature of a multimode waveguide, an advantageous roughness of the NV diamond is determined. In order to simulate the scattering loss due to the roughness present at side wall surfaces of the NV diamond used as a multimode waveguide, the roughness is estimated with the following correlation function (or roughness mode equation) that is used for the side wall surfaces of the NV diamond multimode waveguide:

$$R(\delta) = \sigma^2 \exp\left[-\left(\frac{\delta}{L_c}\right)\right]$$
,

where $L_c$ represents the correlation length, $\sigma$ indicates the root mean square of the surface roughness and $\delta$ represents the coordinates of length in Fourier domain. The inventors have, by simulation using the aforementioned roughness model equation, obtained a graph plotting the roughness for an upper surface and a lower surface as a function of the distance in the elongated NV multimode waveguide in $\mu m$ for an elongated NV diamond multimode waveguide having a length of 1 mm and a rectangular cross-section of 20 $\mu m \times 40 \mu m$. FIG 12 is a 3D model of the final rough surface of such an elongated NV multimode waveguide.

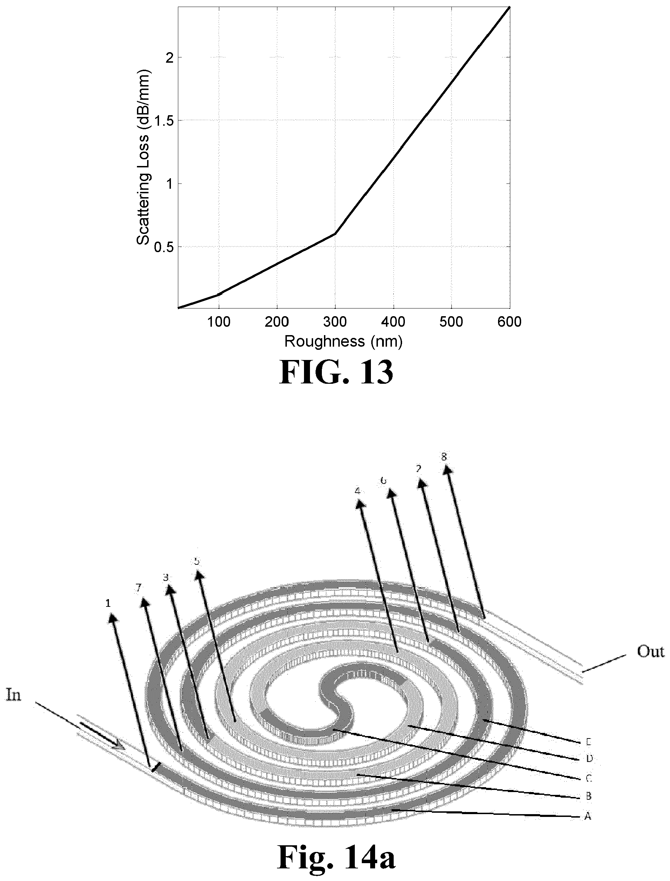

In order to estimate the root mean square $\sigma$ of the surface roughness of side wall surfaces of a 1mm length NV diamond multimode waveguide, the surface roughness of side wall surfaces is varied in different ray-tracing simulations. The results of these simulations, in which the NV diamond multimode waveguide is a 1 mm length NV diamond waveguide with a cross-section of 20 $\mu m \times 40 \mu m$, are shown in FIG. 13, which plots the roughness in nm with respect to the scattering loss in dB/mm. For example, these results show that surface roughness of 300 nm will induce less than 1 dB loss of the green laser light.

Advantageously, for the elongated NV diamond multi-mode waveguide, the roughness is lower than 300 nanometers to obtain a level of loss sufficiently low for certain applications. Preferably, the roughness is lower than 100 nm.

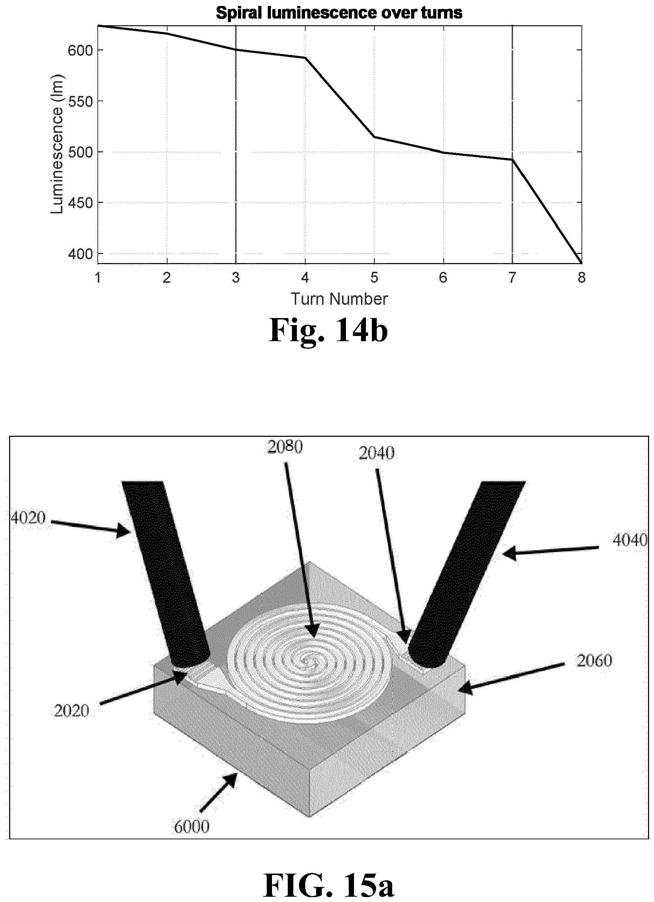

An example of dimensions of the elongated NV diamond multi-mode waveguide would be a 1 mm length, a rectangular cross-section of 40 $\mu m \times 20 \mu m$, a radius of curvature higher than 50 $\mu m$, in particular equal to 150 $\mu m$, and 5 turns. One turn corresponds to a portion of the spiral having a rotation equal to 2pi radian. A rendering of such a NV diamond spiral waveguide with 5 turns is shown in FIG. 14a in which the five turns A, B, C, D and E are distinguished with a different shade of grey. This NV diamond waveguide is excited with a source with numerical aperture equal to 0.5 and with an input power of 628 lm at proximity to point 1 in order to generate a wave propagating from the inlet In to the outlet Out of the elongated NV diamond multi-mode waveguide of FIG. 14a. The power (in lm) at different points 1-8 along the elongated NV diamond multi-mode waveguide of FIG. 14a is reported in the graph of FIG. 14b. According to an embodiment, a circular bend line with a radius of curvature higher than 30 $\mu m$ is used in the center of the spiral. FIG. 14b shows a drop in the center of the spiral, in particular in turn C. According to a variant embodiment, instead of this circular bend line, the center of the spiral can contain an Euler bend in order to attenuate this drop.

According to an embodiment, the elongated NV diamond waveguide is a multi-mode waveguide having the shape of a Fermat's spiral.

According to a non-illustrated variant embodiment, a first reflective coating is applied to one or more external sides of the elongated NV diamond waveguide to enhance collection and excitation. The first reflective coating of the elongated NV diamond waveguide should be as thin as possible to guarantee efficient microwave excitation for the NV sensing application. Different coating materials with a thickness of 50 nm on a diamond of 500 $\mu m$ thickness have been studied using the Fresnel equation. For example, copper or gold can be used. The use of the first reflective coating improves the excitation efficiency - this allows lowering the required excitation light source power.

According to an embodiment (non-illustrated), the diamond waveguide comprises a second reflective coating arranged to reflect both the excitation light and the fluorescence from an extremity of the waveguide opposite to the inlet. In this configuration, a sensor device comprising this diamond waveguide advantageously comprises a single optical fiber arranged to channel the excitation light to the inlet of the diamond waveguide and to collect the fluorescence received from the inlet. The sensor device may comprise a single grating coupler or a first and a second grating couplers configured to be connected to the single optical fiber arranged to channel the excitation light to the elongated NV diamond waveguide and to collect the fluorescence. Preferably, the single optical fiber is arranged to channel the excitation light to the diamond waveguide and to collect the fluorescence from a direction substantially perpendicular to the diamond waveguide, for example from a direction substantially perpendicular to the first plane of the spiral shape.

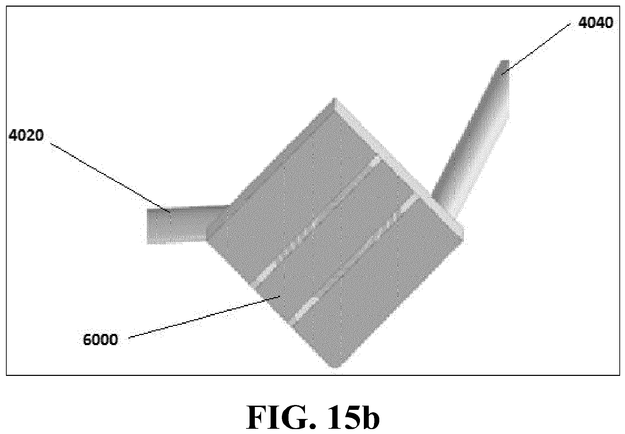

According to another embodiment illustrated by FIG. 15a and FIG. 15b, the sensor device comprises a first optical fiber 4020 arranged to channel the excitation light to the inlet of the elongated NV diamond waveguide 2080 and a second optical fiber 4040 arranged to collect the fluorescence to the outlet of the elongated NV diamond waveguide 2080. Moreover, in order to have an efficient sensor device, the sensor device comprises a first grating coupler 2020 configured to be connected to the first optical fiber 4020 arranged to channel the excitation light to the elongated NV diamond waveguide 2080, for example in a spiral shape, and a second grating coupler 2040 configured to be connected to the second optical fiber 4040 arranged to collect the fluorescence of the elongated NV diamond waveguide 2080. Preferably for the compactness of the sensor device, the first optical fiber 4020 is arranged to channel the excitation light to the elongated NV diamond waveguide 2080 from a direction substantially perpendicular to the elongated NV diamond waveguide 2080. Other angle directions may also be possible depending on the design choice of the elongated NV diamond waveguide 2080. The key is to allow an improved coupling between the first optical fiber 4020 and the elongated NV diamond waveguide 2028. Similarly, the second optical fiber 4040 is arranged to collect the fluorescence from the direction substantially perpendicular to the elongated NV diamond waveguide 2080, for example from the direction substantially perpendicular to the first plane of a spiral shape. However, other angle directions are possible depending on the design choice under the same requirements regarding the optical coupling between the second optical fiber 4040 and the elongated NV diamond waveguide 2080.

The use of separate optical fibers to convey excitation light and collect fluorescence can further enhance the simplicity of the sensor device avoiding the need for a dichroic filter and/or complicated optics.

The use of one or more grating couplers, allowing easy integration of the sensor device and ensuring an improved fluorescence collection (in the typical range of wavelength 600-750nm) in addition to an enhanced excitation efficiency with the green laser at around 532 nm compared to the methods disclosed in [1] [2].

Preferably, the elongated NV diamond waveguide 2080 and the first and second grating couplers 2020 and 2040 (or the single grating coupler) are on a first surface (front surface) in a second plane of a substrate 2060 (for example a $SiO_2$ substrate). For example, the first and second grating couplers 2020 and 2040 (or the single grating coupler) can be single-mode or multimode grating couplers used to couple the perpendicular first and second optical fibers 4020 and 4040 (or the global optical fiber) to the NV diamond 2080.

For example, these grating couplers have a rectangular size with approximately the dimensions 800 $\mu$m $\times$ 800 $\mu$m and the size of the sensor device is, for example, 1mm $\times$ 1mm $\times$ 0.5mm (thickness).

According to a variant embodiment, a mirror is used instead of these reflective coatings.

According to an embodiment, the microwave resonator 6000 is a coplanar microwave structure advantageously deposited on the surface opposite to the first surface of the substrate 2060 on which the elongated NV diamond waveguide is deposited in order to deliver a microwave excitation, in particular magnetic field, required to excite the NV color centers in the NV diamond waveguide (FIGS. 11a and 11b). The use of the coplanar microwave resonator 6000 enhances the delivery of the microwave excitation.

In applications where high sensitivity to physical quantities is required such as magnetic field, electric field, temperature, and pressure, such a sensor device advantageously increases sensitivity.

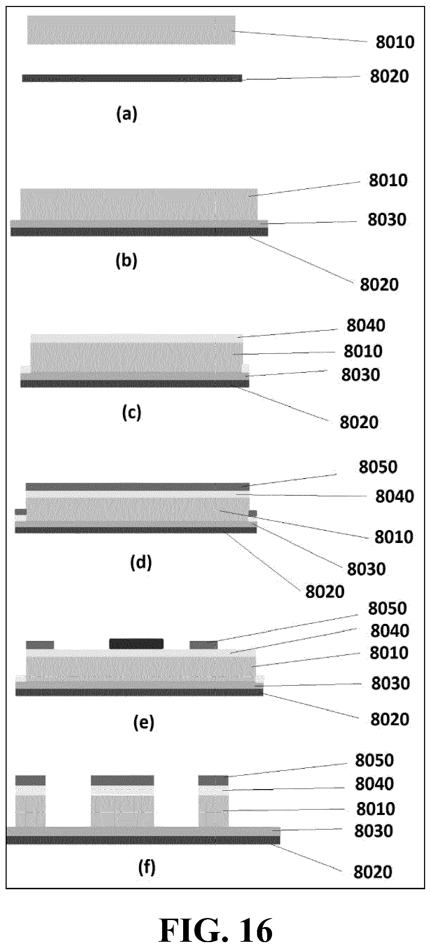

A method of manufacturing the sensor device according to an embodiment of the invention will now be described, with particular reference to steps (a)-(f) of FIG. 16.

In a first step, a NV diamond membrane 8010 having, for example, a thickness approximatively equal to 20 $\mu$m, is provided.

In an optional next step, a step of characterizing the NV diamond membrane 8010 is carried out, with respect to the ODMR in particular.

A step of providing a silicon wafer with a deposited silicon oxide layer 8020 is also carried out.

Then, a step of cleaning the NV diamond membrane 8010 and the front side of the silicon wafer 8020 is carried out (see (a) of FIG.16). This step of cleaning will ensure a clean surface for the next step, i.e. bonding.

Thus, a step of bonding can be carried out at this time (see (b) of FIG.16). This bonding is done using the bonding of an interlayer 8030 made of Hydrogen silsesquioxane (HSQ) and deposited by a spin-coating method. In particular, HSQ is spin-coated on the NV diamond membrane 8010, then, for example, a pressure of 0.05 MPa at a temperature of 250 degrees is applied to the NV diamond membrane 8010 and to the silicon wafer 8020 for bonding. For example, the temperature and pressure treatment can be applied for about 1 hour.

In the next step, a step of deposition of a layer of hard mask 8040, for example titanium, on the NV diamond membrane 8010 is carried out (see (c) of FIG.16). This step of deposition allows to create a hard mask.

Afterwards, a step of depositing an HSQ resist layer 8050 on the layer of titanium 8040 is carried out (see (d) of FIG.16). After Ebeam exposure, the HSQ resist can be developed using Tetra-Methyl-Ammonium hydroxide 25% (TMAH) in order to create a HSQ resist layer 8050 according to a predefined design, in particular to create preferably an elongated NV diamond single-mode or multi-mode waveguide in a spiral shape as described earlier, in view of a subsequent step of Ebeam lithography (see (e) of FIG. 16).

Thus, a step of dry etching can be carried out since the NV diamond membrane 8010 cannot be chemically wet etched (see (f) of FIG.16). We have observed that, it is possible to have very smooth side wall surfaces for over 20 $\mu$m thanks to the use of the layer of titanium 8040 as a hard mask. The titanium will guarantee high etch selectivity against the diamond to achieve a smooth surface. Titanium also does not produce redeposition.

Finally, the remaining layer of titanium 8040 and the HSQ resist layer 8050 can be removed using an HF solution.

Further, for efficient fiber excitation and collection, the elongated NV diamond waveguide that is obtained can be coupled with one or two grating couplers in an additional step. It is also coupled with the single optical fiber used for excitation and collection, or with the first and the second optical fibers, used respectively for excitation and collection.

Finally, during a further step, it is possible to manufacture the coplanar microwave structure, that can be for example a CPW microwave antenna, on the opposite side of the first side (rear side) of the silicon wafer 8020, the opposite side being in a third plane.

This example of manufacturing process is preferably carried out in a cleanroom environment. This example of manufacturing process can be used to obtain a NV diamond single-mode or multi-mode waveguide in a spiral shape.

The different sensor implementations as described can advantageously use commercially available optical fibers.

While in the above exemplary embodiments, nitrogen vacancy diamonds are used as source of light to be collected, other types of material may be used. This comprises but is not limited to materials that produce fluorescence under certain conditions, including diamonds with color centers other than nitrogen-vacancy (for instance SiV or GeV).

References:

[1] Clevenson, Hannah, et al. "Broadband magnetometry and temperature sensing with a light-trapping diamond waveguide." Nature Physics 11.5 (2015): 393-397.
[2] Bougas, Lykourgos, et al. "On the possibility of miniature diamond-based magnetometers using waveguide geometries." Micromachines 9.6 (2018): 276.
[3] Tien, PK V. "Light waves in thin films and integrated optics." Applied optics 10.11 (1971): 2395-2413.

<div align="center">References to the Drawings</div>

| | | | |
|---|---|---|---|
| 40 | Microprocessor | 2020 | first grating coupler |
| 41 | NV diamond | 2040 | second grating coupler |
| 42 | Green light source | 2060 | substrate |
| 43 | Microwave source | 2080 | NV diamond waveguide |
| 44 | Microwave resonator | 4020 | first optical fiber |
| 45 | Bias magnet | 4040 | second optical fiber |
| 46 | Green/red light separator | 6000 | microwave resonator |
| 47 | Photodetector | 8010 | NV diamond membrane |
| 48 | Lock-in amplifier | 8020 | Silicon wafer deposited with a layer of silicon oxide |
| 48a | Mixer | | |
| 48b | Low pass filter | 8030 | interlayer |
| 48c | Local oscillator | 8040 | layer of titanium |
| 49 | Connection module | 8050 | HSQ resist layer |

**Claims**

1. A source of fluorescence shaped as a diamond waveguide comprising:

- defects in a diamond configured to emit a fluorescence when submitted to an excitation light provided by a source of excitation, and
- an inlet through which said excitation light is arranged to be introduced,

wherein said diamond waveguide has an elongated shape and is arranged to couple said excitation light and said defects through the length of the diamond waveguide.

2. Source of fluorescence according to claim 1, wherein said defects comprise nitrogen-vacancy centers, said fluorescence is function of a physical phenomenon to be sensed such as a magnetic field, temperature, pressure, or an electric field.

3. Source of fluorescence according to one of claims 1 or 2, wherein said diamond waveguide is formed in a photonic crystal structure, the periodicity of the photonic crystal structure being of the same order of magnitude as the wavelength of excitation light and/or with the wavelength of the fluorescence.

4. Source of fluorescence according to one of claims 1 or 2, wherein said diamond waveguide has the shape of a spiral comprising turns having a common center and two coplanar branches connected at said common center, said spiral being in a first plane.

5. Source of fluorescence according to claim 4, wherein said elongated diamond waveguide comprises at least 5 turns.

6. Source of fluorescence according to one of the claims 4 or 5, wherein said elongated diamond waveguide is a single-mode waveguide or a multimode-waveguide having a roughness at its side wall surfaces lower than 100 nm and each turn being defined by a radius of curvature higher than 50 $\mu$m.

7. Source of fluorescence according to one of claims 1 to 6, wherein the diamond waveguide is coated with a first reflective coating, a material of said first reflective coating being adapted to reflect both fluorescence and excitation light.

8. Source of fluorescence according to one of claims 1 to 7, wherein said diamond waveguide comprises a second reflective coating arranged to reflect both excitation light and fluorescence from an extremity of said waveguide opposite to said inlet, a material of said second reflective coating being adapted to reflect both fluorescence and excitation light.

9. A sensor device comprising

  - a source of fluorescence according to one of the claims 1 to 7;
  - a first optical fiber arranged to channel said excitation light to said inlet of said diamond waveguide;
  - a second optical fiber arranged to collect said fluorescence.

10. A sensor device comprising

  - a source of fluorescence according to claim 8;
  - a single optical fiber is arranged to channel said excitation light to said diamond waveguide and to collect said fluorescence.

11. Sensor device according to one of the claims 9 or 10, wherein said diamond waveguide comprises a first grating coupler configured to be connected to said source of excitation and/or a second grating coupler configured to be connected to said collector.

12. Sensor device according to one of the claims 9 to 11, wherein said diamond waveguide is deposited on a first side of a substrate, said first side being in a second plane.

13. Sensor device according to claim 12, further comprising a coplanar microwave resonator optionally deposited on an opposite side of the first side of the substrate, said opposite side being in a third plane.

14. Sensor device according to claim 13, wherein said diamond waveguide has the shape of a spiral comprising turns having a common center and two coplanar branches connected at said common center, said spiral being in a first plane, wherein a first optical fiber is arranged to channel said excitation light to said waveguide from a direction substantially perpendicular to said first plane, wherein a second optical fiber is arranged to collect the fluorescence from a direction substantially perpendicular to said first plane.

15. Magnetometer comprising a sensor device according to one of the claims 9 to 14.

**FIG. 1**

**FIG. 2**

**FIG. 3**

**FIG. 4**

**FIG. 5**

**FIG. 6**

# FIG. 7

wavelength in nm

# FIG. 8

**FIG. 9**

**FIG. 10**

## FIG. 11

## FIG. 12

FIG. 13

Fig. 14a

**Spiral luminescence over turns**

Fig. 14b

FIG. 15a

**FIG. 15b**

8010

8020

(a)

8010

8030

8020

(b)

8040
8010
8030

8020

(c)

8050

8040

8010

8030

8020

(d)

8050
8040
8010
8030

8020

(e)

8050
8040
8010
8030

8020

(f)

**FIG. 16**

**EUROPEAN SEARCH REPORT**

Europäisches Patentamt
European Patent Office
Office européen des brevets

Application Number

EP 22 30 5258

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 10 901 054 B1 (CHEN EDWARD H [US] ET AL) 26 January 2021 (2021-01-26) <br> * column 4, line 50 - line 67; figures 1C, 2A * <br> * column 7, line 25 - line 30 * <br> * column 8, line 8 - line 16 * <br> ----- | 1 | INV. <br> G01R33/32 <br> G01R33/26 <br> G01N24/00 <br><br> ADD. <br> G01R33/032 |
| X <br> Y <br> A | EP 3 904 897 A1 (UNIV MUENCHEN TECH [DE]) 3 November 2021 (2021-11-03) <br> * paragraphs [0044], [0066], [0069]; <br> figures 1,4 * <br> ----- | 1,2,7,8 <br> 9,15 <br> 3-6,14 | |
| X <br> Y <br> A | DE 10 2019 220353 A1 (BOSCH GMBH ROBERT [DE]) 24 June 2021 (2021-06-24) <br> * paragraphs [0013], [0040], [0049]; <br> figures 9,10b * <br> ----- | 1,2 <br> 3,9-13, 15 <br> 4-6,14 | |
| Y | US 2011/062957 A1 (FU KAI-MEI CAMILLA [US] ET AL) 17 March 2011 (2011-03-17) <br> * paragraph [0050] * <br> ----- | 9-13 | |
| Y | PATEL R.L. ET AL: "Subnanotesla Magnetometry with a Fiber-Coupled Diamond Sensor", <br> PHYSICAL REVIEW APPLIED, <br> vol. 14, no. 4, <br> 30 October 2020 (2020-10-30), XP055947679, <br> DOI: 10.1103/PhysRevApplied.14.044058 <br> * figure 1b * <br> ----- <br> -/-- | 9,10 | TECHNICAL FIELDS SEARCHED (IPC) <br><br> G01R <br> G01N |

The present search report has been drawn up for all claims

| Place of search | Date of completion of the search | Examiner |
|---|---|---|
| Munich | 2 August 2022 | Skalla, Jörg |

EPO FORM 1503 03.82 (P04C01)

page 1 of 3

Europäisches
Patentamt

European
Patent Office

Office européen
des brevets

# EUROPEAN SEARCH REPORT

Application Number

EP 22 30 5258

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | GIAKOUMAKI A N ET AL: "Quantum technologies in diamond enabled by laser processing", APPLIED PHYSICS LETTERS, AMERICAN INSTITUTE OF PHYSICS, 2 HUNTINGTON QUADRANGLE, MELVILLE, NY 11747, vol. 120, no. 2, 10 January 2022 (2022-01-10), XP012262658, ISSN: 0003-6951, DOI: 10.1063/5.0080348 [retrieved on 2022-01-10] * the whole document * | 1 | |
| Y | HAUSMANN B. J. M. ET AL: "Coupling of NV Centers to Photonic Crystal Nanobeams in Diamond", NANO LETTERS, [Online] vol. 13, no. 12, 15 November 2013 (2013-11-15), pages 5791-5796, XP055947907, US ISSN: 1530-6984, DOI: 10.1021/nl402174g Retrieved from the Internet: URL:https://pubs.acs.org/doi/pdf/10.1021/n1402174g> [retrieved on 2022-08-01] * the whole document * | 3 | TECHNICAL FIELDS SEARCHED (IPC) |
| A | WO 2021/164142 A1 (UNIV SCIENCE & TECHNOLOGY CHINA [CN]) 26 August 2021 (2021-08-26) * the whole document * | 1,3 | |

-/--

The present search report has been drawn up for all claims

| Place of search | Date of completion of the search | Examiner |
|---|---|---|
| Munich | 2 August 2022 | Skalla, Jörg |

EPO FORM 1503 03.82 (P04C01)

Europäisches
Patentamt

European
Patent Office

Office européen
des brevets

# EUROPEAN SEARCH REPORT

**Application Number**

EP 22 30 5258

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | JIXING ZHANG ET AL: "Diamond Nitrogen-Vacancy Center Magnetometry: Advances and Challenges", ARXIV.ORG, CORNELL UNIVERSITY LIBRARY, 201 OLIN LIBRARY CORNELL UNIVERSITY ITHACA, NY 14853, 20 October 2020 (2020-10-20), XP081790927, * chapter 4 * | 1-15 | |
| A | ALEXANDER LANDOWSKI ET AL: "Coherent Remote Control over Nano-Emitters Embedded in Polymer Waveguides", ARXIV.ORG, CORNELL UNIVERSITY LIBRARY, 201 OLIN LIBRARY CORNELL UNIVERSITY ITHACA, NY 14853, 30 November 2018 (2018-11-30), XP080940848, * figure 1 * | 1 | |
| A | LEE JUNYI ET AL: "Integrated single photon emitters", AVS QUANTUM SCIENCE, AMERICAN INSTITUTE OF PHYSICS, 2 HUNTINGTON QUADRANGLE, MELVILLE, NY 11747, vol. 2, no. 3, 20 August 2020 (2020-08-20), XP012249518, DOI: 10.1116/5.0011316 [retrieved on 2020-08-20] * figure 14 * | 1,3 | **TECHNICAL FIELDS SEARCHED (IPC)** |
| A | CN 111 896 895 A (UNIV SCIENCE & TECHNOLOGY CHINA) 6 November 2020 (2020-11-06) * figures 1,2 * | 1,10 | |

The present search report has been drawn up for all claims

| Place of search | Date of completion of the search | Examiner |
|---|---|---|
| Munich | 2 August 2022 | Skalla, Jörg |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 30 5258

This annex lists the patent family members relating to the patent documents cited in the above-mentioned European search report.
The members are as contained in the European Patent Office EDP file on
The European Patent Office is in no way liable for these particulars which are merely given for the purpose of information.

02-08-2022

| Patent document cited in search report | | Publication date | Patent family member(s) | | Publication date |
|---|---|---|---|---|---|
| US 10901054 | B1 | 26-01-2021 | US | 10901054 B1 | 26-01-2021 |
| | | | US | 11150313 B1 | 19-10-2021 |
| EP 3904897 | A1 | 03-11-2021 | EP | 3904897 A1 | 03-11-2021 |
| | | | EP | 3997472 A1 | 18-05-2022 |
| | | | WO | 2021219516 A1 | 04-11-2021 |
| DE 102019220353 | A1 | 24-06-2021 | NONE | | |
| US 2011062957 | A1 | 17-03-2011 | NONE | | |
| WO 2021164142 | A1 | 26-08-2021 | CN | 111323617 A | 23-06-2020 |
| | | | WO | 2021164142 A1 | 26-08-2021 |
| CN 111896895 | A | 06-11-2020 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **CHATZIDROSOS, GEORGIOS et al.** Fiberized Diamond-Based Vector Magnetometers. *Frontiers in Photonics,* 2021
- **CLEVENSON, HANNAH et al.** Broadband magnetometry and temperature sensing with a light-trapping diamond waveguide. *Nature Physics,* 2015, vol. 11 (5), 393-397
- **BOUGAS, LYKOURGOS et al.** On the possibility of miniature diamond-based magnetometers using waveguide geometries. *Micromachines,* 2018, vol. 9 (6), 276
- **TIEN, PK V.** Light waves in thin films and integrated optics. *Applied optics,* 1971, vol. 10 (11), 2395-2413